**Europäisches Patentamt**

**European Patent Office**

**Office européen des brevets**

(11) Veröffentlichungsnummer: **0 329 933**
**A2**

## (12) EUROPÄISCHE PATENTANMELDUNG

(21) Anmeldenummer: **89100443.4**

(22) Anmeldetag: **12.01.89**

(51) Int. Cl.⁴: **H05K 9/00**

(30) Priorität: **25.02.88 DE 8802435 U**
**11.03.88 DE 8803296 U**

(43) Veröffentlichungstag der Anmeldung:
**30.08.89 Patentblatt 89/35**

(84) Benannte Vertragsstaaten:
**AT BE CH DE ES FR GB GR IT LI LU NL SE**

(71) Anmelder: **Albers, Gerd**
**Grosser Kamp 5**
**D-2000 Barsbüttel(DE)**

(72) Erfinder: **Albers, Gerd**
**Grosser Kamp 5**
**D-2000 Barsbüttel(DE)**

(74) Vertreter: **von Raffay, Vincenz, Dipl.-Ing. et al**
**Patentanwälte Raffay, Fleck & Partner**
**Postfach 32 32 17**
**D-2000 Hamburg 13(DE)**

(54) **Verbindungsvorrichtung für metallische Wandelemente.**

(57) Die Verbindungsvorrichtung für metallische Wandelemente in gegen elektromagnetische Strahlung abgeschirmten Räumen, insbesondere für Datenverarbeitungsgeräte, ist so gestaltet, daß die Wandelemente 1 an ihren Verbindungs- oder Stoßkanten in Profile 6 eingehängt sind. Die Verbindungs- oder Stoßkanten der Wandelemente sind in ihren Endbereichen (bei 5) U-förmig gestaltet. In die Stoßfuge zwischen den aneinander angrenzenden Wandelemente 1 ist eine elastische Verbindungsschiene 10 eingeschoben, die elektrisch leitend ist. Die Ausgestaltung ist in unterschiedlicher Weise möglich. Die Verbindungsschiene 10 stellt eine sichere mechanische und elektrisch leitende Verbindung zwischen den Wandelementen dar. Gleichzeitig sorgt sie für einen optisch guten Abschluß. Die Verbindungsschiene 10 kann leicht de- oder entmontiert werden.

Fig.2

## Verbindungsvorrichtung für metallische Wandelemente

Die Erfindung betrifft eine Verbindungsvorrichtung für metallische Wandelemente in gegen elektromagnetische Strahlung abgeschirmten Räumen, insbesondere für Datenverarbeitungsgeräte, wobei die Wandelemente an ihren Verbindungs- oder Stoßkanten in Profile eingehängt sind.

Es sind verschiedene Möglichkeiten zur Auskleidung von besonders abzuschirmenden Räumen bekannt. Hierzu werden vorgefertigte Wandelemente verwendet, die aus Metall bestehen, so daß sie elektrisch leitend sind und nach Art eines faradayischen Käfigs für die gewünschte Abschirmung sorgen. In bekannter Weise werden die Wandelemente durch Verschraubung oder Schweißen in den Räumen miteinander verbunden, um nicht nur für die entsprechende Stabilität sondern vor allem für die elektrische Verbindung zu sorgen, damit die geforderte Abschirmung gewährleistet ist. Die Verschraubungen sind unschön, da sie in den Raum vorstehen und sichtbar sind. Gleichzeitig bergen sie eine Verletzungsgefahr. Auch ist eine solche Verschraubung arbeitsaufwendig, da sie jeweils einzeln in dem entsprechenden Raum hergestellt werden muß. Wenn die Wandelemente miteinander verschweißt werden, so stellt dieses einen erheblichen Aufwand dar, da ein Schweißen nur dann möglich ist, wenn die Datenverarbeitungsanlagen entweder nicht vorhanden oder besonders geschützt sind.

Der Erfindung liegt nun die Aufgabe zugrunde, eine einfache Verbindungsmöglichkeit für die Wandelemente in besonders abgeschirmten Räumen der eingangs genannten Art zu schaffen.

Diese Aufgabe wird grundsätzlich bei einer Verbindungsvorrichtung der eingangs genannten Art dadurch gelöst, daß die Verbindungs- oder Stoßkanten der Wandelemente jeweils in ihren Endbereichen U-förmig gestaltet sind,und daß in die Stoßfuge zwischen den aneinander angrenzenden Wandelementen eine elastische Verbindungsschiene eingeschoben wird, die elektrisch leitend ist.

Nach dem Aufstellen der Wandelemente - das Wort "Wandelemente" schließt auch Boden- und Deckenelemente ein -werden die Verbindungsschienen entsprechend der Länge der Stoßfugen zwischen den Wandelementen zugeschnitten und in diese eingedrückt. Dadurch, daß die Verbindungsschienen, ob nun durch ihre Außenhaut oder durch ihren Kern, elastisch sind, wird für eine gute Verbindung auch unter Berücksichtigung entsprechender Toleranzen im Abstand zwischen den Wandelementen gesorgt. Gleichzeitig wird die erforderliche elektrisch leitende Verbindung sichergestellt. Wenn die Wandelemente demontiert werden sollen, so kann die Verbindungsschiene leicht wieder entfernt werden.

Der Innenraum oder auch die Innenräume der Verbindungsschiene können entweder durch einen Kern aus elastischem Material, vorzugsweise Kunststoffmaterial, gefüllt sein, oder sie sind hohl und können als Kabel- oder Lüftungsschächte zur Verfügung stehen. Die Elastizität kann durch die Außenhaut, vorzugsweise Metallblech oder aber Kern aus elastischem Material (oder durch eine Kombination von beiden) bedingt sein.

In vorteilhafter Weise ist die Verbindungsvorrichtung so ausgebildet, wie in Anspruch 4 angegeben. Hier sind zwei nach außen offene Abschnitte vorhanden, die durch entsprechende U-förmige Endprofile gebildet werden. In diese Abschnitte wird die entsprechend gestaltete Verbindungsschiene formschlüssig eingeschoben. Wenn, wie in Anspruch 6 unter Schutz gestellt, die U-förmigen Endprofile noch durch eine Umklammerung nach Art eines Blechdosenverschlusses miteinander verbunden sind, dann wird für eine gute elektrische Verbindung und für eine gute mechanische Verbindung gesorgt. Es entsteht eine ansprechende und den technischen Anforderungen gerecht werdende Verbindung zwischen den Wandelementen, die leicht zusammenbaubar und wieder lösbar ist.

Im folgenden wird die Erfindung unter Hinweis auf die Zeichnung anhand eines Ausführungsbeispieles näher erläutert.

Es zeigt:

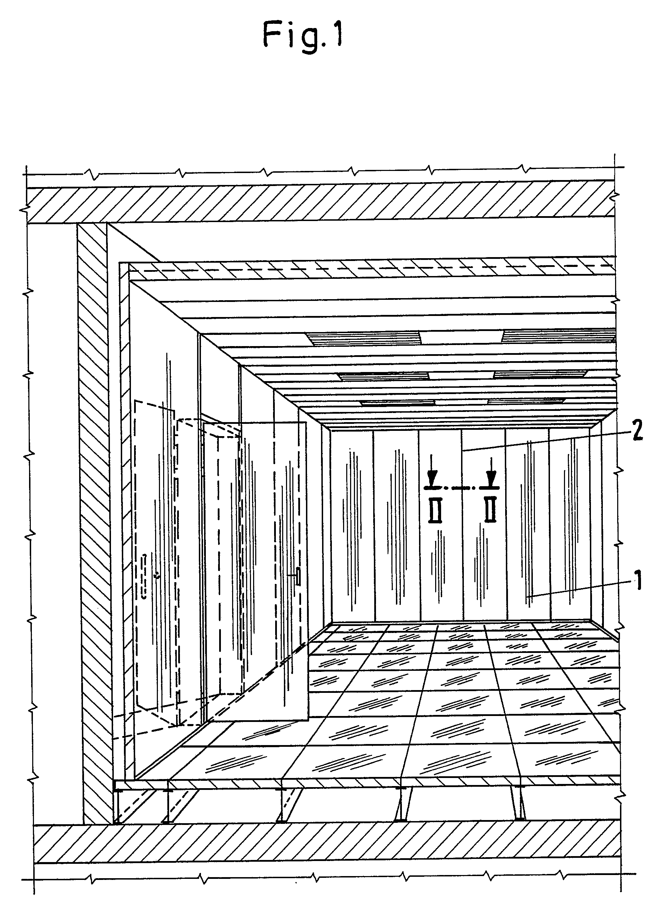

Fig. 1 eine perspektivische Teilansicht eines Raumes mit Wandelementen zur Verbindung durch eine Verbindungsschiene;

Fig. 2 einen Schnitt gemäß der Linie II-II der Fig. 1 durch eine Ausführungsform einer Verbindungsvorrichtung nach der Erfindung.

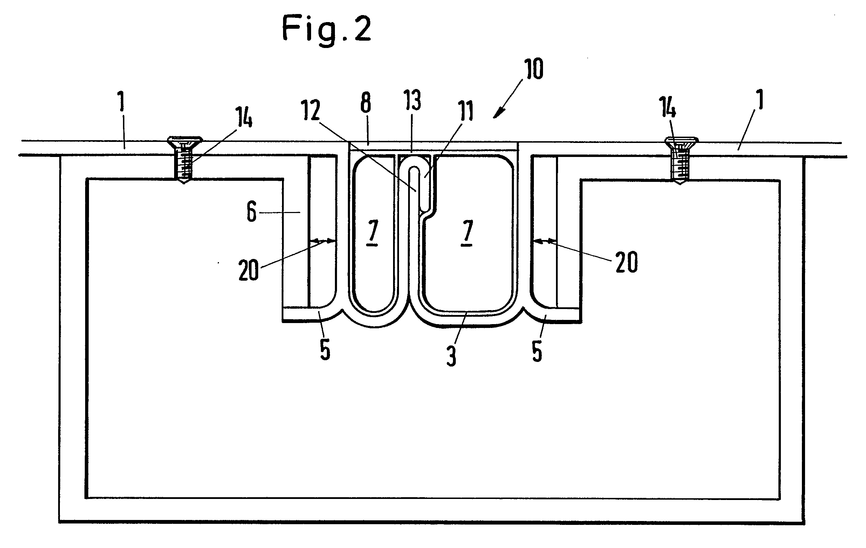

Aus Fig. 2 ist ersichtlich, daß zwischen zwei Wandelementen 1, die in ein Profil 6 eingehängt sind, eine Stoßfuge gebildet wird, die von einer im Querschnitt dargestellten Verbindungsschiene 10 ausgefüllt wird. Dabei weisen die Wandelemente zur Bildung U-förmig gestalteter Endbereiche zwei zurückgebogene Stege 5 auf, die unmittelbar auf den Enden der Profile 6 aufliegen und so für eine sichere Einhängung sorgen. Um eine weitere Befestigung der Wandelemente an den Profilen 6 zu ermöglichen, werden Schrauben 14 verwendet. Der Einsatz und die Anzahl der Schrauben 14 ist aber nicht kritisch.

An den durch die Stege 5 gebildeten U-förmigen Endbereichen sind nach außen offene, ebenfalls U-förmige Endprofile 11 und 12 ausgebildet, die in der durch das Profil 6 definierten Stoßfuge liegen. Das eine Endprofil 12 ist im Querschnitt etwas größer oder breiter als das andere 11, wobei das Ende des Endprofils 12 gerade ist, während das Ende des Endprofils 11 über das Ende des Endprofils 12 nach Art eines Dosenverschlusses gebogen ist und so für eine Umklammerung sorgt. Hierdurch wird eine sichere mechanisch und elektrisch leitende Verbindung geschaffen. Diese beiden Enden der Endprofile 11 und 12 werden mittels eines nicht gezeigten Werkzeuges zusammengepreßt. In die Stoßfuge und damit auch in die U-förmigen Endprofile wird eine Verbindungsschiene 10 eingeschoben, die, bedingt durch ihre Elastizität, dort einschnappt, d.h. eine formschlüssige Verbindung herstellt. Diese Verbindungsschiene besteht aus zwei einander gegenüberliegenden Abschnitten (mit Kern 7), die durch elastisches Kunststoffmaterial ausgefüllt sind. Die Außenhaut 3 dieser Abschnitte ist durch einen Steg 13 an der Vorderseite miteinander verbunden, um für die elektrisch leitende Verbindung und einen guten Abschluß zu sorgen. Die Abschnitte (mit Kern 7) können entweder - wie dargestellt mit einem elastischen Kunststoffmaterial ausgefüllt sein oder sie können hohl sein und als Kabel- oder Lüftungsschächte dienen. Im letzteren Falle wird die Elastizität durch die Außenhaut 3 aus Metallblech allein bedingt.

Um nach außen hin einen möglichst ansehnlichen Abschluß zu erreichen, der die Stoßfuge darüber hinaus im wesentlichen unsichtbar macht, wird eine Dekorleiste 8 auf den Steg 13 aufgesetzt, der gestalterisch dem Dekor der Wandelemente angepaßt ist.

## Ansprüche

1. Verbindungsvorrichtung für metallische Wandelemente in gegen elektromagnetische Strahlung abgeschirmten Räumen, insbesondere für Datenverarbeitungsgeräte, wobei die Wandelemente (1) an ihren Verbindungs- oder Stoßkanten in Profile (6) eingehängt sind, dadurch gekennzeichnet, daß die Verbindungs- oder Stoßkanten der Wandelemente (1) jeweils in ihren Endbereichen U-förmig (bei 5) gestaltet sind, und daß in die Stoßfuge zwischen den aneinander angrenzenden Wandelementen (1) eine elastische Verbindungsschiene (10) eingeschoben wird, die elektrisch leitend ist.

2. Verbindungsvorrichtung nach Anspruch 1, dadurch gekennzeichnet, daß die Verbindungsschiene (10) eine die Elastizität bedingende Außenhaut (3) aus Metallblech aufweist.

3. Verbindungsvorrichtung nach Anspruch 1 oder 2, dadurch gekennzeichnet, daß der Innenraum der Verbindungsschiene (10) einen Kern (7) aus elastischem Material, vorzugsweise Kunststoffmaterial, aufweist.

4. Verbindungsvorrichtung nach einem der vorstehenden Ansprüche, dadurch gekennzeichnet, daß in der Stoßfuge an den U-förmigen Endbereichen (5) der Wandelemente (1) nach außen offene, U-förmige Endprofile (11,12) ausgebildet sind, in deren nach außen offenen Abschnitt die elastische Verbindungsschiene (10) eingeschoben ist.

5. Verbindungsvorrichtung nach Anspruch 4, dadurch gekennzeichnet, daß der eine nach außen offene Abschnitt größer ist als der andere.

6. Verbindungsvorrichtung nach Anspruch 4 oder 5, dadurch gekennzeichnet, daß die aneinander angrenzenden Stege der U-förmigen Endprofile (11,12) zur Herstellung einer elektrischen Verbindung einander umklammern.

7. Verbindungsvorrichtung nach einem der Ansprüche 4 oder 5, dadurch gekennzeichnet, daß die entsprechend den nach außen offenen Abschnitten ausgebildete Verbindungsschiene (10) an ihrer Vorderseite einen Verbindungssteg (13) aus Metallblech aufweist, der die Außenhaut (3) aus Metallblech der die Abschnitte ausfüllenden Körper miteinander verbindet.

8. Verbindungsvorrichtung nach einem oder mehreren der vorstehenden Ansprüche, dadurch gekennzeichnet, daß außen auf der Verbindungsschiene (10) eine Dekorleiste (8) vorgesehen ist.

# Fig.1

# Fig.2

EP 0 329 933 A2